# EUROPÄISCHE PATENTSCHRIFT

(11) **EP 3 753 038 B1**
(45) Veröffentlichungstag und Bekanntmachung des Hinweises auf die Patenterteilung: **22.01.2025**
(21) Anmeldenummer: 19714994.1
(22) Anmeldetag: 13.02.2019
(51) Int. Cl.: H01J 37/04, H01J 37/28

(54) **VIELSTRAHL-TEILCHENMIKROSKOP**
MULTI-BEAM ELECTRON MICROSCOPE
MICROSCOPE À PARTICULES MULTIFAISCEAUX

(30) Priorität: 16.02.2018 DE 102018202428
(43) Veröffentlichungstag der Anmeldung: 23.12.2020
(73) Patentinhaber: Carl Zeiss MultiSEM GmbH, 73447 Oberkochen (DE)
(72) Erfinder: ZEIDLER, Dirk, 73447 Oberkochen (DE); SCHUBERT, Stefan, 73447 Oberkochen (DE)
(74) Vertreter: Diehl & Partner
(86) Internationale Anmeldenummer: PCT/EP2019/053526
(87) Internationale Veröffentlichungsnummer: WO 2019/158573

(56) Entgegenhaltungen:
- DE-A1- 102013 016 113
- JP-A- 2005 005 178
- JP-A- 2007 059 111
- US-A1- 2010 320 382
- US-A1- 2014 361 167
- US-A1- 2017 154 756
- US-B1- 6 465 783

## Beschreibung

Die Erfindung betrifft ein Vielstrahl-Teilchenmikroskop.

Beispielsweise aus WO 2012/041464 A1 und DE 10 2016 120 902 A1 sind Vielstrahl-Teilchenmikroskope bekannt, bei welchen eine Vielzahl von Primär-Teilchenstrahlen eines Bündels aus Primär-Teilchenstrahlen auf ein Objekt fokussiert werden. Die Primär-Teilchenstrahlen erzeugen an den Orten ihres Auftreffens auf dem Objekt Sekundärelektronen, welche durch ein an das Objekt angelegtes elektrisches Feld von dem Objekt weg beschleunigt und zu Sekundär-Teilchenstrahlen geformt werden, welche auf eine Detektoranordnung mit einer Vielzahl von Detektoren gerichtet werden. Hierbei erzeugt jeder einzelne Primär-Teilchenstrahl am Ort seines Auftreffens auf dem Objekt einen dem Primär-Teilchenstrahl zugeordneten Sekundär-Teilchenstrahl, und der Sekundär-Teilchenstrahl trifft auf wenigstens einen ihm zugeordneten Detektor der Detektoranordnung, so dass durch Detektieren der auf diesen wenigstens einen Detektor treffenden Teilchenintensität Information zu dem Ort des Objekts gewonnen werden kann, auf welchen der Primär-Teilchenstrahl gerichtet ist. Das Bündel aus Primär-Teilchenstrahlen kann durch das Vielstrahl-Teilchenmikroskop abgelenkt werden und das Objekt kann relativ zu dem Vielstrahl-Teilchenmikroskop verlagert werden, um dessen Oberfläche systematisch mit den Primär-Teilchenstrahlen abzutasten und aus den dabei detektierten Intensitäten an Sekundär-Teilchenstrahlen ein elektronenmikroskopisches Bild des Objekts zu gewinnen.

Ein ähnliches Vielstrahl-Teilchenstrahlmikroskop ist in US 2010/0320382 A1 offenbart. JP 2007-059111 A offenbart ein Einstrahl-Elektronenmikroskop, mit welchem Rückstreuelektronen, die unter kleinen Startwinkeln von dem Objekt ausgehen, detektiert werden sollen. Hierzu wird eine Platte mit einem Loch oder ein Netz mit dem Objekt in Kontakt gebracht.

Es hat sich gezeigt, dass sich mit dem bekannten Vielstrahl-Teilchenmikroskop bestimmte Strukturen an Objekten nicht so deutlich und kontrastreich im elektronenmikroskopischen Bild sichtbar machen lassen wie dies mit Einstrahl-Teilchenmikroskopen der Fall ist.

Entsprechend ist es eine Aufgabe der vorliegenden Erfindung, ein Vielstrahl-Teilchenmikroskop vorzuschlagen, welches erweiterte Möglichkeiten aufweist, um Strukturen an Objekten deutlich und kontrastreich im elektronenmikroskopischen Bild sichtbar zu machen.

Diese Aufgabe wird gelöst durch die Bereitstellung eines Vielstrahl-Teilchenstrahlmikroskops mit den in dem beiliegendem Anspruch 1 angegebenen Merkmalen. Vorteilhafte Ausführungsformen sind in den beiliegenden abhängigen Ansprüchen angegeben.

Erfindungsgemäß umfasst ein Vielstrahl-Teilchenmikroskop eine Vielstrahl-Teilchenquelle, welche dazu konfiguriert ist, eine Vielzahl von Primär-Teilchenstrahlen zu erzeugen; eine Objektivlinse, welche von Strahlengängen der Vielzahl von Primär-Teilchenstrahlen durchsetzt ist und dazu konfiguriert ist, die Vielzahl von Primär-Teilchenstrahlen jeweils auf eine Objektebene zu richten und dort zu fokussieren; eine Detektoranordnung, welche dazu konfiguriert ist, Intensitäten einer Vielzahl von Elektronenstrahlen zu detektieren, wobei Elektronen der Elektronenstrahlen durch Teilchen der Primär-Teilchenstrahlen an einem in der Objektebene anordenbaren Objekt erzeugt werden.

Im Betrieb des Vielstrahl-Teilchenmikroskops durchsetzt ein jeder der Primär-Teilchenstrahlen eine Apertur einer Multi-Aperturplatte und trifft fokussiert auf dem Objekt auf. Am Ort des Auftreffens auf dem Objekt erzeugt der Primär-Teilchenstrahl Sekundärelektronen, welche aus dem Objekt austreten und hin zu der Multi-Aperturplatte beschleunigt werden. Diese Sekundärelektronen durchsetzen die Apertur der Multi-Aperturplatte in eine Richtung weg von dem Objekt und bilden einen Elektronenstrahl, welcher die Objektivlinse durchsetzt und zu der Detektoranordnung geführt wird.

Die durch den Primär-Teilchenstrahl erzeugten Sekundärelektronen haben bei ihrem Austritt aus der Oberfläche des Objekts typischerweise kinetische Energien, welche unabhängig von der kinetischen Energie der auftreffenden Primär-Teilchen sind und typischerweise kleiner als 50 eV sind. Allerdings werden durch den Primär-Teilchenstrahl üblicherweise auch sogenannte Rückstreuelektronen erzeugt, welche an der Stelle des Auftreffens des Primär-Teilchenstrahls aus dem Objekt austreten und kinetische Energien aufweisen, welche größer als 50 eV sind und bis zur kinetischen Energie der Primär-Teilchen reichen können. Die Erfinder haben erkannt, dass diese im Vergleich zu den Sekundärelektronen höherenergetischen Elektronen in nur sehr geringem Umfang zu der Detektoranordnung geführt werden und dort Detektionssignale erzeugen. Bei Einstrahl-Teilchenmikroskopen ist es jedoch möglich, Rückstreuelektronen gesondert zu detektieren und aus Detektionssignalen von Rückstreuelektronen elektronenmikroskopische Bilder zu erzeugen, welche verschiedene Materialien in einem Objekt mit einem hohen Kontrast voneinander unterscheidbar darstellen. Die Erfinder haben festgestellt, dass es wünschenswert wäre, auch bei dem Vielstrahl-Teilchenmikroskop die Möglichkeit zu haben, Rückstreuelektronen effizient zu detektieren. Die Erfinder haben weiter erkannt, dass die Elektronenstrahlen, welche vom Objekt ausgehen und zu der Detektoranordnung geführt werden, im Wesentlichen aus Sekundärelektronen gebildet sind, da diese aufgrund ihrer niedrigen Energie beim Austritt aus der Oberfläche des Objekts zu den einzelnen Elektronenstrahlen gebündelt werden können, während die wesentlich höherenergetischen Rückstreuelektronen nicht zu einzelnen Elektronenstrahlen geformt werden können, welche ausgehend von dem Ort des Auftreffens des Primär-Teilchenstrahls auf das Objekt hin zu einem diesen Ort zugeordnetem Element der Detektoranordnung geführt werden können.

Die Multi-Aperturplatte des Vielstrahl-Teilchenmikroskops umfasst deshalb eine Vielzahl von Konvertern, wobei an jeder Öffnung der Vielzahl von Öffnungen wenigstens ein Konverter der Vielzahl von Konvertern vorgesehen ist, wobei die Konverter dazu konfiguriert sind, von den Primär-Teilchenstrahlen an dem Objekt erzeugte Rückstreuelektronen, welche an dem Objekt kinetische Energien aufweisen, die größer sind als ein vorbestimmter erster Energieschwellwert, in Elektronen umzuwandeln, welche an dem Konverter kinetische Energien aufweisen, die kleiner sind als ein vorbestimmter zweiter Energieschwellwert und welche Elektronen bereitstellen, die die von der Detektoranordnung detektierten Elektronenstrahlen bilden.

Damit werden die Rückstreuelektronen mit ihrer vergleichsweise hohen kinetischen Energie nahe an dem Objekt und nahe an dem Ort, an dem sie aus der Oberfläche des Objekts austreten, in Elektronen wesentlich niedrigerer kinetischer Energie umgewandelt. Diese Elektronen niedrigerer kinetischer Energie entstehen in der Nähe der Auftrefforte der Primär-Teilchenstrahlen auf dem Objekt. Die dort entstehenden Elektronen niedriger kinetischer Energie können dann - wie die an dem Ort des Auftreffens des Primär-Teilchenstrahls erzeugten Sekundärelektronen - ebenfalls zu Elektronenstrahlen geformt werden und der Detektoranordnung zur Detektion zugeführt werden. Dort erzeugen diese umgewandelten niederenergetischen Elektronen Detektionssignale, welche proportional zur Anzahl der an dem Ort des Auftreffens des Primär-Teilchenstrahls erzeugten rückgestreuten Elektronen ist. Somit ist es aufgrund der Bereitstellung der Konverter an der Multi-Aperturplatte möglich, mit dem Vielstrahl-Teilchenmikroskop ebenfalls Rückstreuelektronen zu detektieren.

Gemäß beispielhaften Ausführungsformen umfassen die Konverter jeweils eine dünne Membran, welche im Wesentlichen parallel zu der Objektebene orientiert ist. Die dünnen Membranen können hierbei die Aperturen in der Multi-Aperturplatte definieren bzw. begrenzen. Die an dem Objekt erzeugten Rückstreuelektronen können auf die der Objektebene zugewandte Oberfläche der Membran auftreffen und durch diese in die Elektronen niedrigerer Energie umgewandelt werden, welche wenigstens zum Teil aus der von der Objektebene abgewandten Oberfläche der Membran austreten und zu dem Elektronenstrahl beitragen können, welcher die Objektivlinse durchsetzt und der Detektoranordnung zugeführt wird.

Gemäß beispielhaften Ausführungsformen liegt die Dicke der Membranen in einem Bereich von 0,5 nm bis 50 nm und insbesondere in einem Bereich von 4 nm bis 20 nm.

Eine hohe Umwandlungsrate von Rückstreuelektronen in die Elektronen niedrigerer Energie kann beispielsweise dann erreicht werden, wenn die Membranen aus einem Material aus schweren Elementen bestehen. Gemäß beispielhaften Ausführungsformen bestehen die Membranen aus einem Material, welches aus Atomen besteht, die Kernladungszahlen aufweisen, welche im Mittel größer als 40 sind. Beispiele für derartige Materialien sind Gold und andere. Membranen aus schweren Elementen sollten jedoch ausreichend dünn sein, um eine zu starke Absorption der Sekundärelektronen durch die Membran zu vermeiden. Beispielsweise kann eine Monolage aus Gold als Membran verwendet werden. Die dünne Schicht aus Gold kann beispielsweise auf eine dickere stabilere Trägerschicht aus beispielsweise Aluminium aufgedampft sein.

Gemäß beispielhaften Ausführungsformen sind die Konverter jeweils aus einem Material gebildet, welches an Innenwänden der Öffnungen der Multi-Aperturplatte vorgesehen ist. Gemäß beispielhaften Ausführungsformen ist dieses Material verschieden von einem Material, welches das Strukturmaterial der Multi-Aperturplatte ist. Das Material, welches den Konverter bildet, ist dann beispielsweise als eine Schicht an den Innenwänden der Öffnungen der Multi-Aperturplatte angebracht.

Gemäß beispielhaften Ausführungsformen besteht das Material aus Atomen, die Kernladungszahlen aufweisen, welche im Mittel größer als 40 sind.

Gemäß weiteren beispielhaften Ausführungsformen weisen die Öffnungen der Multi-Aperturplatte eine konische Gestalt derart auf, dass sich der Querschnitt einer Öffnung in Richtung weg von der Objektebene verkleinert. Gemäß beispielhaften Ausführungsformen weisen die Öffnungen der Multi-Aperturplatte auf ihrer der Objektebene zugewandten Seite eine erste Querschnittsfläche und auf ihrer von der Objektebene abgewandten Seite eine zweite Querschnittsfläche auf, wobei die erste Querschnittsfläche wenigstens 1,5 mal und insbesondere wenigstens 2,0 mal größer ist als die zweite Querschnittsfläche.

Gemäß beispielhaften Ausführungsformen umfasst das Vielstrahl-Teilchenmikroskop ein Spannungsversorgungssystem, welches dazu konfiguriert ist, dem Objekt und der Multi-Aperturplatte jeweils ein einstellbares elektrisches Potential zuzuführen.

Gemäß einer beispielhaften Ausführungsform hierin ist das Spannungsversorgungssystem dazu konfiguriert, in einem ersten Betriebsmodus einer dem Objekt zuweisenden Seite der Multi-Aperturplatte und dem Objekt elektrische Potentiale derart zuzuführen, dass das Objekt relativ zu der Multi-Aperturplatte auf einem negativen elektrischen Potential liegt, so dass an dem Objekt erzeugte Sekundärelektronen die Öffnungen der Multi-Aperturplatte durchsetzen und ebenfalls Elektronen bereitstellen, die die von der Detektoranordnung detektierten Elektronenstrahlen bilden; und wobei das Spannungsversorgungssystem dazu konfiguriert ist, in einem zweiten Betriebsmodus der dem Objekt zuweisenden Seite der Multi-Aperturplatte und dem Objekt elektrische Potentiale derart zuzuführen, dass das Objekt relativ zu der Multi-Aperturplatte auf einem positiven elektrischen Potential liegt, so dass an dem Objekt erzeugte Sekundärelektronen die Öffnungen der Multi-Aperturplatte nicht durchsetzen. Damit ist es möglich, wahlweise zwischen einem Betriebsmodus, in welchem Sekundärelektronen zu den durch die Detektoranordnung detektierten Elektronenstrahlen beitragen, und einem Betriebsmodus umzuschalten, in dem Sekundärelektronen nicht zu den detektierten Elektronen beitragen und somit lediglich die an dem Objekt erzeugten Rückstreuelektronen zu den detektierte Elektronen beitragen. In diesem Fall ist das durch die detektierten Elektronen erzeugte elektronenmikroskopische Bild ein so genanntes reines Rückstreuelektronenbild.

Gemäß beispielhaften Ausführungsformen umfasst die Multi-Aperturplatte drei voneinander isolierte leitfähige Schichten, wobei das Spannungs-Versorgungssystem dazu konfiguriert ist, den drei leitfähigen Schichten jeweils einstellbare elektrische Potentiale zuzuführen.

Der erste Energieschwellwert kann beispielsweise größer als 50 eV oder größer als 200 eV sein. Der zweite Energieschwellwert kann beispielsweise kleiner als 200 eV und insbesondere kleiner als 100 eV sein. Die Anzahl der Primär-Teilchenstrahlen kann beispielsweise größer als 7 oder größer als 50 sein.

Gemäß beispielhaften Ausführungsformen ist die Multi-Aperturplatte mit einem Abstand von der Objektebene angeordnet, welcher kleiner als 200 µm, insbesondere kleiner als 50 µm, insbesondere kleiner als 30 µm, insbesondere kleiner als 20 µm und insbesondere kleiner als 10 µm ist.

Gemäß beispielhaften Ausführungsformen ist die Multi-Aperturplatte mit einem Abstand von der Objektebene angeordnet, welcher kleiner ist als ein geringster Abstand der Aperturen der Multi-Aperturplatte voneinander.

Gemäß weiteren beispielhaften Ausführungsformen ist ein minimaler Abstand zwischen zwei einander benachbarten Primär-Teilchenstrahlen an der Multi-Aperturplatte kleiner als 50 µm, insbesondere kleiner als 30 µm, insbesondere kleiner als 20 µm und insbesondere kleiner als 12 µm ist.

Ausführungsformen der Erfindung werden nachfolgend anhand von Figuren näher erläutert. Hierbei zeigt:
- Figur 1: eine schematische Darstellung zur Erläuterung einer Funktionsweise eines Vielstrahl-Teilchenmikroskops gemäß einer Ausführungsform;
- Figur 2: eine schematische Darstellung eines Teils des Vielstrahl-Teilchenmikroskops der Figur 1;
- Figur 3: eine schematische Schnittdarstellung einer Multi-Aperturplatte mit Konvertern des Vielstrahl-Teilchenmikroskops der Figur 1 gemäß einer ersten Ausführungsform;
- Figur 4: eine schematische Schnittdarstellung einer Multi-Aperturplatte mit Konvertern des Vielstrahl-Teilchenmikroskops der Figur 1 gemäß einer zweiten Ausführungsformen; und
- Figur 5: eine schematische Schnittdarstellung einer Multi-Aperturplatte mit Konvertern des Vielstrahl-Teilchenmikroskops der Figur 1 gemäß einer dritten Ausführungsformen.

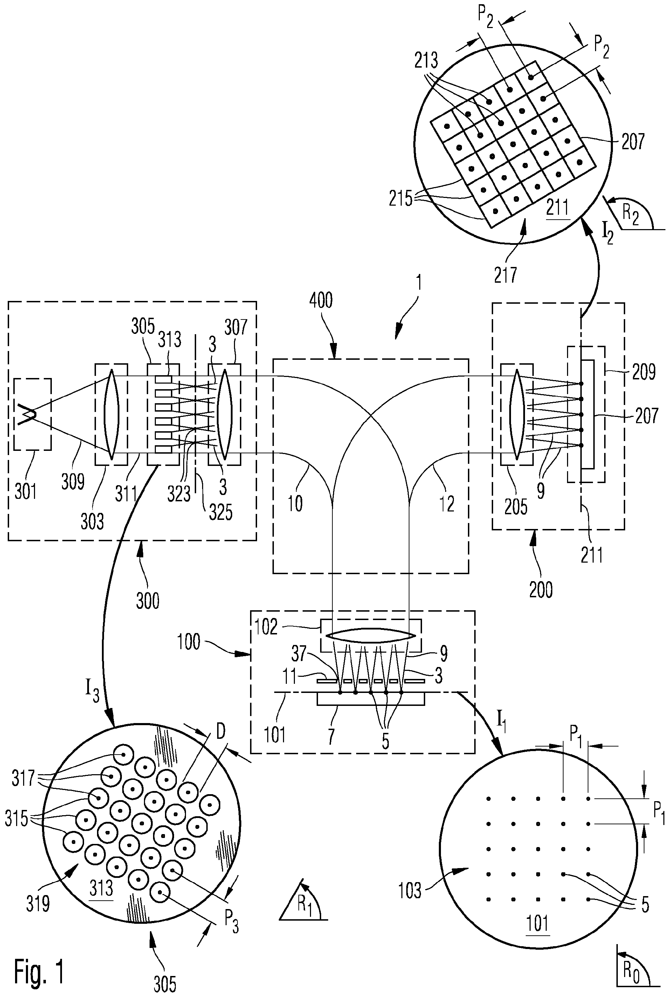

Figur 1 ist eine schematische Darstellung eines Vielstrahl-Teilchenmikroskops, welches mehrere Teilchenstrahlen einsetzt. Das Vielstrahl-Teilchenmikroskop erzeugt mehrere Primär-Teilchenstrahlen, welche auf ein zu untersuchendes Objekt treffen, um dort Sekundär-Teilchen zu erzeugen, welche von dem Objekt ausgehen und zu Sekundär-Teilchenstrahlen geformt werden, welche nachfolgend detektiert werden. Das Vielstrahl-Teilchenmikroskop 1 ist vom Rasterelektronenmikroskoptyp ("scanning electron microscope", SEM), welches als Primär-Teilchenstrahlen Elektronenstrahlen 3 einsetzt, die an Orten 5 auf einer Oberfläche des Objekts 7 auftreffen und dort mehrere Elektronenstrahlflecken bzw. Elektronenspots erzeugen. Die an diesen Strahlflecken auf das Objekt auftreffenden Elektronen des Primär-Teilchenstrahls erzeugen Elektronen als Sekundär-Teilchen, welche zu Sekundär-Teilchenstrahlen geformt und detektiert werden. Diese als Sekundär-Teilchen erzeugten Elektronen werden häufig hinsichtlich ihrer kinetischen Energie in Rückstreuelektronen und Sekundärelektronen eingeteilt. Im Allgemeinen werden Elektronen mit kinetischen Energien, die kleiner als 50 eV sind, als Sekundärelektronen und Elektronen mit kinetischen Energien, die größer als 50 eV sind, als Rückstreuelektronen bezeichnet.

Allerdings können die Primär-Teilchenstrahlen auch Ionenstrahlen sein. Diese können beim Auftreffen auf dem Objekt ebenfalls Elektronen als Sekundär-Teilchen erzeugen, welche zu Sekundär-Teilchenstrahlen geformt und detektiert werden. Auch hier können Elektronen mit kinetischen Energien, die kleiner als 50 eV sind, als Sekundärelektronen und Elektronen mit kinetischen Energien, die größer als 50 eV sind, als Rückstreuelektronen bezeichnet werden.

Das zu untersuchende Objekt 7 kann von einer beliebigen Art sein und beispielsweise einen Halbleiter-Wafer, eine biologische Probe und eine Anordnung miniaturisierter Elemente oder dergleichen umfassen. Die Oberfläche des Objekts 7 ist in einer Objektebene 101 einer Objektivlinse 102 eines Objektivlinsensystems 100 angeordnet.

Der vergrößerte Ausschnitt I1 der Figur 1 zeigt eine Draufsicht auf die Objektebene 101 mit einem regelmäßigen rechtwinkligen Feld 103 von Auftrefforten 5 von Primär-Teilchenstrahlen 3, welche in der Ebene 101 gebildet werden. In Figur 1 beträgt die Zahl der Auftrefforte 25, welche als ein 5 x 5-Feld 103 angeordnet sind. Die Zahl 25 an Auftrefforten ist eine aus Gründen der vereinfachten Darstellung gewählte kleine Zahl. In der Praxis kann die Zahl an Strahlen bzw. Auftrefforten wesentlich größer gewählt werden, wie beispielsweise 20 x 30, 100 x 100 und dergleichen.

In der dargestellten Ausführungsform ist das Feld 103 von Auftrefforten 5 ein im Wesentlichen regelmäßiges rechtwinkliges Feld mit einem konstanten Abstand p1 zwischen benachbarten Auftrefforten. Beispielhafte Werte des Abstands p1 sind 50 µm, 30 µm oder 10 µm. Es ist jedoch auch möglich, dass das Feld 103 andere Symmetrien aufweist, wie beispielsweise eine hexagonale Symmetrie.

Ein Durchmesser der in der Objektebene 101 geformten Strahlflecken kann klein sein. Beispielhafte Werte dieses Durchmessers betragen 1 nm, 5 nm, 10 nm und 30 nm. Das Fokussieren der Partikelstrahlen 3 zur Formung der Strahlflecken 5 erfolgt durch das Objektivlinsensystem 100.

Die auf das Objekt treffenden Teilchen, welche in dem hier erläuterten Beispiel Elektronen sind, erzeugen wiederum Teilchen, welche im Wesentlichen Elektronen sind, und welche von der Oberfläche des Objekts 7 ausgehen. Die von der Oberfläche des Objekts 7 ausgehenden Elektronen werden durch das Objektivlinsensystem 100 zu Elektronenstrahlen 9 geformt. Das Vielstrahl-Teilchenmikroskop 1 stellt einen Sekundärstrahlengang 12 bereit, um die Vielzahl von Elektronenstrahlen 9 einem Detektionssystem 200 zuzuführen. Das Detektionssystem 200 umfasst eine Elektronenoptik mit einem Projektivlinsensystem 205, um die Elektronenstrahlen 9 auf einen Elektronen-Multi-Detektor 209 zu richten.

Der Ausschnitt I2 in Figur 1 zeigt eine Draufsicht auf eine Ebene 211, in welcher einzelne Detektionsbereiche angeordnet sind, auf welche die Elektronenstrahlen 9 an Orten 213 auftreffen. Die Auftrefforte 213 bilden ein zweites Feld 217 mit einem regelmäßigen Abstand p2 der Auftrefforte voneinander. Beispielhafte Werte des Abstands p2 sind 10 µm, 100 µm, 200 µm und 500 µm.

Die Primär-Teilchenstrahlen 3 werden durch eine Vielstrahl-Teilchenquelle 300 erzeugt, welche wenigstens eine Elektronenquelle 301 mit einem Elektronenemitter, wenigstens eine Kollimationslinse 303, eine Multi-Aperturanordnung 305 und ein Feldlinsensystem 307 umfasst. Die Elektronenquelle 301 erzeugt aus von dem Elektronenemitter emittierten Elektronen einen divergierenden Elektronenstrahl 309, welcher durch die Kollimationslinse 303 kollimiert wird, um einen Strahl 311 zu formen, welcher die Multi-Aperturanordnung 305 beleuchtet.

Der Ausschnitt I3 in Figur 1 zeigt eine Draufsicht auf die Multi-Aperturanordnung 305. Die Multi-Aperturanordnung 305 umfasst eine Multi-Aperturplatte 313, welche eine Mehrzahl von darin ausgebildeten Öffnungen bzw. Aperturen 315 aufweist. Mittelpunkte 317 der Öffnungen 315 sind in einem Feld 319 angeordnet, welches dem Feld 103 entspricht, welches durch die Strahlflecken 5 in der Objektebene 101 gebildet wird. Ein Abstand p3 der Mittelpunkte 317 der Aperturen 315 voneinander kann beispielhafte Werte von 5 µm, 100 µm und 200 µm aufweisen. Die Durchmesser D der Aperturen 315 sind kleiner als der Abstand p3 der Mittelpunkte der Aperturen voneinander. Beispielhafte Werte der Durchmesser D sind 0,2 x p3, 0,4 x p3 und 0,8 x p3.

Elektronen des beleuchtenden Strahls 311 durchsetzen die Aperturen 315 und bilden Elektronenstrahlen 3 als Primär-Teilchenstrahlen. Elektronen des beleuchtenden Strahls 311, welche auf die Platte 313 treffen, werden durch diese abgefangen und tragen nicht zur Bildung der Elektronenstrahlen 3 bei.

Die Multi-Aperturanordnung 305 fokussiert die Elektronenstrahlen 3 derart, dass in einer Ebene 325 Strahlfoki 323 gebildet werden. Ein Durchmesser der Foki 323 kann beispielsweise 2 nm, 10 nm, 100 nm und 1 µm betragen.

Das Feldlinsensystem 307, ein Strahlteiler 400 und die Objektivlinse 102 stellen eine erste abbildende Teilchenoptik bereit und bilden einen Primärstrahlengang 10, um die Ebene 325, in der die Foki 323 gebildet werden, auf die Objektebene 101 abzubilden, so dass dort ein Feld 103 von Auftrefforten 5 bzw. Strahlflecken auf der Oberfläche des Objekts 7 gebildet wird.

Die Objektivlinse 102, der Strahlteiler 400 und das Projektivlinsensystem 205 stellen eine zweite abbildende Teilchenoptik bereit und bilden einen Sekundärstrahlengang 12, um die Objektebene 101 auf die Detektionsebene 211 abzubilden. Die Objektivlinse 102 ist somit eine Linse, welche sowohl Teil des Primärstrahlengang 10 als auch des Sekundärstrahlengangs 12 ist, während das Feldlinsensystem 307 nur dem Primärstrahlengang 10 und das Projektivlinsensystem 205 nur dem Sekundärstrahlengang 12 angehört. Die Objektivlinse 102 wird somit sowohl von den Strahlengängen der Primär-Teilchenstrahlen 3 als auch von den Strahlengängen der (sekundären) Elektronenstrahlen durchsetzt.

Der Strahlteiler 400 ist in dem Primärstrahlengang 10 zwischen der Multi-Aperturanordnung 305 und dem Objektivlinsensystem 100 angeordnet. Der Strahlteiler 400 ist auch Teil des Sekundärstrahlengangs 12 und ist dort zwischen dem Objektivlinsensystem 100 und dem Detektionssystem 200 angeordnet. Der Strahlteiler 400 trennt die Strahlengänge der Primär-Teilchenstrahlen 10 von den Strahlengängen der (sekundären) Elektronenstrahlen.

Weitergehende Information zu solchen Vielstrahl-Teilchenmikroskopen und darin eingesetzten Komponenten, wie etwa Teilchenquellen, Multi-Aperturplatten und Linsen, kann aus den internationalen Patentanmeldungen WO 2005/024881 A2, WO 2007/028595 A2, WO 2007/028596 A1 und WO 2007/060017 A2 und den Patentanmeldungen US 2015/0083911 A1, US 2015/0069235 A1, DE 10 2014 008 383 A1, US 6,946,655 B2 und DE 10 2016 120 902 A1 erhalten werden.

Das Vielstrahl-Teilchenmikroskop 1 umfasst ferner eine zwischen der Objektivlinse 102 und der Objektebene 101 angeordnete Multi-Aperturplatte 11, welche eine Vielzahl von Öffnungen 37 aufweist. In der in Figur 1 erläuterten Ausführungsform sind in der Multi-Aperturplatte 11 25 Öffnungen derart vorgesehen, dass im Betrieb des Vielstrahl-Teilchenmikroskops 1 eine jede der Öffnungen 37 von einem Primär-Teilchenstrahl 3 durchsetzt wird und von einem (sekundären) Elektronenstrahl 9 durchsetzt werden kann.

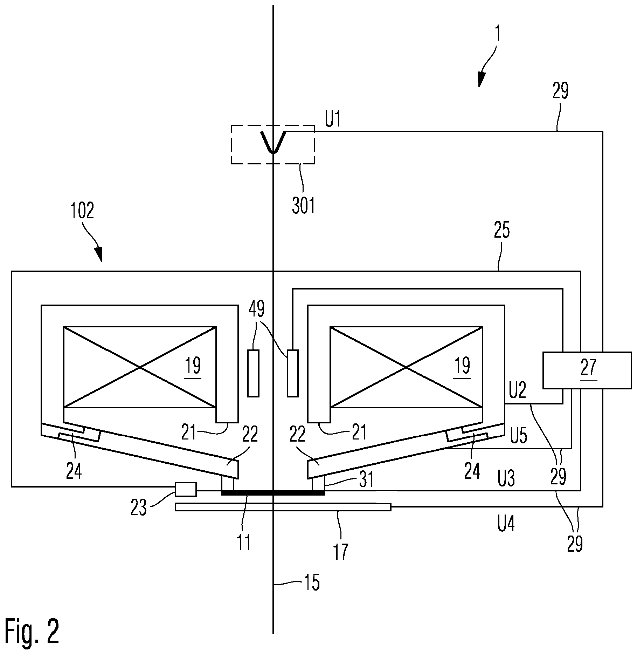

Figur 2 zeigt in vereinfachter schematischer Darstellung die Objektivlinse 102, welche einen Spulenkörper 19, einen oberen Polschuh 21 und einen unteren Polschuh 22 umfasst, so dass zwischen diesen ein Spalt gebildet ist, an dem ein die Primär-Teilchenstrahlen fokussierendes Magnetfeld erzeugt wird. Die Multi-Aperturplatte 11 ist über eine elektrisch isolierende Halterung 31 an dem unteren Polschuh 22 der Objektivlinse 102 gehaltert und an diesen befestigt. Alternativ zu der Befestigung der Multi-Aperturplatte 11 an der Objektivlinse 102 ist es möglich, dass ein Aktuator 23 vorgesehen ist, welcher die Aperturplatte aus dem Bereich zwischen der Objektivlinse 102 und der Objektebene 101 wahlweise entfernen oder dort anordnen kann, wobei die Multi-Aperturplatte 11 bei ihrer Anordnung zwischen der Objektivlinse 102 und der Objektebene 101 durch einen geeigneten Mechanismus gegen die als Abstandshalter wirkende Halterung 31 gedrückt wird. Der Aktuator 23 wird über eine Steuerleitung 25 durch eine Steuerung 27 des Vielstrahl-Teilchenmikroskops 1 kontrolliert.

Die Steuerung 27 umfasst ferner ein Spannungsversorgungssystem, um den Teilchenemitter der Teilchenquelle 301 auf ein erstes elektrisches Potential U1 zu setzen, den oberen Polschuh 21 der Objektivlinse 102 auf ein zweites elektrisches Potential U2 zu setzen, die Multi-Aperturplatte 11 auf ein drittes elektrisches Potential U3 zu setzen, die Objekthalterung 17 mit dem darauf angeordneten Objekt 7 auf ein viertes elektrisches Potential U4 zu setzen und den unteren Polschuh 22 der Objektivlinse 102 auf ein fünftes elektrisches Potential U5 zu setzen. Zur Zuführung der elektrischen Potentiale U1, U2, U3, U4 und U5 an den Teilchenemitter der Teilchenquelle 301, den oberen Polschuh 21, die Multi-Aperturplatte 11, die Objekthalterung 17 und den unteren Polschuh 22 sind Potentialzuführungsleitungen 29 zwischen diesen Komponenten und der Steuerung 27 vorgesehen.

Ein zwischen dem Ende des oberen Polschuhs 21 und dem Ende des unteren Polschuhs 22 sich in der Objektivlinse erstreckender magnetischer Eisenkreis ist durch einen elektrischen Isolator 24 getrennt, welcher es ermöglicht, den oberen und den unteren Polschuh auf unterschiedliche elektrische Potentiale U2 bzw. U5 zu setzen. Der Isolator 24 ist hierbei so gestaltet, dass die beiden an den Isolator 24 angrenzenden Teile des Eisenkreises geometrisch überlappen, um einen geringen Widerstand für den magnetischen Fluss zu erreichen.

Die Differenz zwischen den Potentialen U1 und U4 bestimmt die kinetische Energie, mit welcher die Teilchen der Primär-Teilchenstrahlen 3 auf das Objekt treffen. Diese Differenz kann beispielsweise Werte zwischen 50 V und 3 kV annehmen.

Im Strahlengang der Primär-Teilchenstrahlen 3 kann in der Teilchenquelle 301 oder nachfolgend eine Elektrode (Anode) angeordnet sein, um die Teilchen auf eine große kinetische Energie zu beschleunigen, so dass sie die Strecke bis zur Objektivlinse 102 und durch diese hindurch schnell zurücklegen. Diese Elektrode kann ebenfalls auf das zweite elektrische Potential U2 gesetzt werden. Die Differenz zwischen U1 und U2 bestimmt dann die kinetische Energie der Teilchen zwischen der Vielstrahl-Teilchenquelle und dem Objektiv 102 und kann beispielsweise größer als 5 kV, größer als 15 kV oder größer als 25 kV sein. Zwischen dem oberen Polschuh 21, der auf das zweite elektrische Potential U2 gesetzt ist, und dem unteren Polschuh 22, der auf das fünfte elektrische Potential U5 gesetzt ist, besteht ein elektrisches Feld, welches die Primärteilchen auf ihrem Weg hin zu dem Objekt 7 verzögert und die Elektronenstrahlen 9 auf ihrem Weg hin zu dem Detektor beschleunigt. Ferner ist die Multi-Aperturplatte 11 auf das dritte elektrische Potential U3 gesetzt.

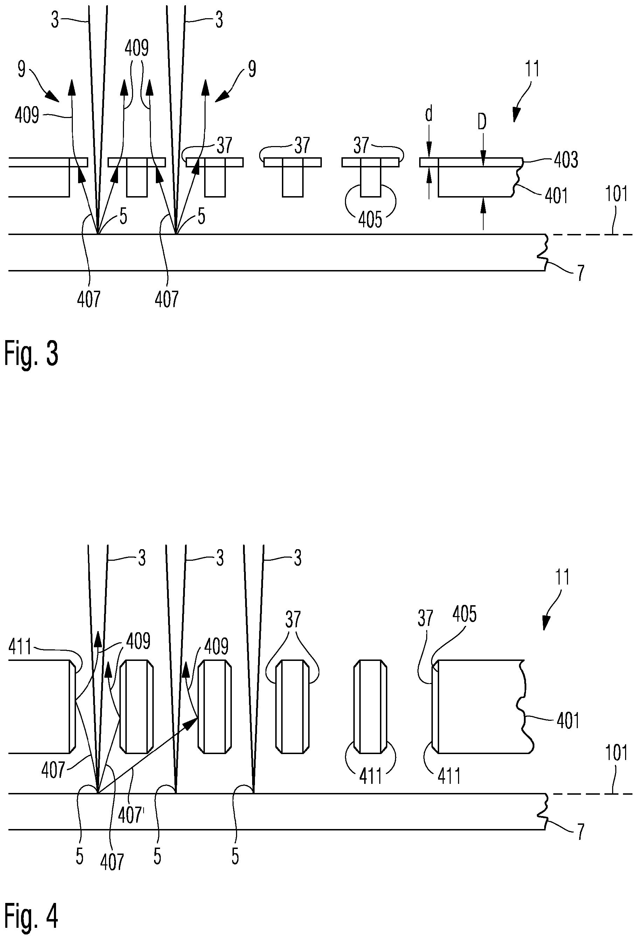

Figur 3 ist eine vergrößerte Darstellung der Multi-Aperturplatte 11 im Querschnitt. Die Multi-Aperturplatte 11 umfasst ein tragendes Substrat 401, auf welches eine Konverterschicht 403 aufgebracht ist. In der Konverterschicht sind die Öffnungen 37, welche von den Primär-Teilchenstrahlen 3 auf ihrem Weg hin zu dem Objekt 7 durchsetzt werden, angebracht. Die Öffnungen 37 können beispielsweise kreisrunde Öffnungen sein und einen Durchmesser von beispielsweise 1 µm, 2 µm oder 5 µm aufweisen.

Das Substrat 401 weist Durchgangslöcher 405 mit einem Durchmesser auf, welcher wesentlich größer ist als der Durchmesser der Ausnehmungen 37 in der Konverterschicht 403 und welche bezüglich der Ausnehmungen 37 in der Konverterschicht 403 derart angeordnet sind, dass die Öffnungen 405 in dem Substrat 401 durch die Konverterschicht teilweise abgedeckt werden. Die Konverterschicht 403 definiert und begrenzt somit die von den Primär-Teilchenstrahlen 3 durchsetzten Öffnungen 37. Ferner bestehen Bereiche der Konverterschicht 403 entlang des Umfangs der Öffnungen 37, an welchen die Konverterschicht 403 nicht von dem Substrat 401 unterstützt wird.

Der Durchmesser der Ausnehmungen 37 in der Konverterschicht 403 ist dabei auf den Strahldurchmesser der Primär-Teilchenstrahlen 3 so abgestimmt, dass die Primärteilchen vor dem Auftreffen auf dem Objekt 7 keinen nennenswerten Störuntergrund an von diesen unmittelbar an der Konverterschicht erzeugten Sekundärelektronen verursachen. Beispielsweise beträgt der Strahldurchmesser der Primär-Teilchenstrahlen 3 höchstens 70%, insbesondere höchstens 50% und insbesondere höchstens 20% des Durchmessers der Ausnehmungen 37 in der Konverterschicht 403. Der Kipppunkt des Strahlablenksystems zum Abscannen des Objekts 7 mit den Primär-Teilchenstrahlenbündeln 3 sollte so nahe an der Ebene der Konverterschicht 403 liegen, dass auch beim Abscannen des Objekts eine Auswanderung der Primär-Teilchenstrahlenbündel 3 in der Ebene der Konverterschicht 403 hinreichend klein bleibt, so dass die Primärteilchen vor dem Auftreffen auf dem Objekt 7 keinen nennenswerten Störuntergrund an von diesen unmittelbar an der Konverterschicht erzeugten Sekundärelektronen verursachen.

Die auf das Objekt 7 treffenden Teilchen des Primär-Teilchenstrahls 3 erzeugen an dem Auftreffort 5 auf der Oberfläche des Objekts 7 durch Wechselwirkung der Teilchen mit dem Material des Objekts 7 Elektronen, welche aus der Oberfläche des Objekts 7 austreten. Üblicherweise werden diese durch die Primärteilchen erzeugten Elektronen in zwei Kategorien unterteilt, nämlich zum einen Sekundärelektronen und zum anderen Rückstreuelektronen. Die Rückstreuelektronen weisen bei ihrem Austritt aus der Oberfläche des Objekts 7 kinetische Energien auf, welche der kinetischen Energie der einfallenden Primärteilchen entsprechen oder etwas kleiner als diese sind. Die Sekundärelektronen weisen Energien auf, welche wesentlich kleiner sind als die kinetische Energie der auftreffenden Primärteilchen.

Sowohl die Rückstreuelektronen als auch die Sekundärelektronen treten aus der Oberfläche des Objekts 7 in einem breiten Raumwinkelbereich aus. Beim herkömmlichen Vielstrahl-Teilchenmikroskop besteht zwischen der Objektivlinse und dem Objekt ein elektrisches Feld, welches zum einen die Teilchen der Primär-Teilchenstrahlen auf ihrem Weg hin zu dem Objekt verzögert und zum anderen die aus dem Objekt austretenden Elektronen weg von dem Objekt beschleunigt. Da die aus dem Objekt austretenden Sekundärelektronen bei ihrem Austritt aus dem Objekt recht kleine kinetische Energien aufweisen, wird deren kinetische Energie, Geschwindigkeit und Bewegungsrichtung im Wesentlichen durch das elektrische Feld bestimmt, welches die Elektronen weg von dem Objekt beschleunigt. Insbesondere sind die Geschwindigkeitskomponenten der aus dem Objekt austretenden Sekundärelektronen in Richtung parallel zu der Oberfläche des Objekts gering, so dass sich die Sekundärelektronen nach einer erfolgten Beschleunigung durch das zwischen dem Objekt und der Objektivlinse bereitgestellte elektrische Feld im Wesentlichen senkrecht zu der Objektebene 101 von dem Objekt 7 weg bewegen. Bei einem ausreichenden Abstand der Orte 5 voneinander überlagern sich Trajektorien von Sekundärelektronen, welche an einander benachbarten Orten 5 aus dem Objekt 7 austreten, deshalb kaum. Dadurch ist es möglich, aus den aus dem Objekt 7 austretenden Sekundärelektronen Elektronenstrahlen 9 zu formen, welche in dem Sekundärstrahlengang 12 als separate Strahlen zu der Detektoranordnung 211 geführt werden können.

Da die Rückstreuelektronen bei ihrem Austritt aus dem Objekt 7 eine recht große kinetische Energie aufweisen, wird deren kinetische Energie, Bewegungsgeschwindigkeit und Bewegungsrichtung nach Beschleunigung in dem zwischen der Objektivlinse und dem Objekt 7 bereitgestellten elektrischen Feld nicht vorrangig durch dieses Feld sondern ebenfalls maßgeblich durch deren Bewegungsrichtung beim Austritt aus der Oberfläche des Objekts bestimmt. Wenn bei einem gegebenen Abstand zwischen einander benachbarten Auftrefforten 5 der Primärstrahlen 3 auf dem Objekt 7 die parallel zu der Objektebene 101 orientierten Komponenten der Geschwindigkeiten der aus dem Objekt austretenden Rückstreuelektronen ausreichend groß sind, so können sich Trajektorien von Rückstreuelektronen, welche an einander benachbarten Orten 5 aus dem Objekt 7 austretenden, überlappen. Dann ist es nicht möglich, solche Rückstreuelektronen, welche von verschiedenen Auftrefforten 5 ausgehen, durch den Sekundärstrahlengang 12 als separate Strahlen zu der Detektoranordnung zu führen. Diese Situation entsteht bei Rückstreuelektronen aufgrund von deren relativ großer kinetischen Energie beim Austritt aus dem Objekt für einen relativ großen Teil der austretenden Rückstreuelektronen, so dass die Effizienz, mit der Rückstreuelektronen den einzelnen Auftrefforten 5 zuordenbar detektiert werden, sehr gering ist. Dies führt dazu, dass beim herkömmlichen Vielstrahl-Teilchenmikroskop Kontraste zwischen verschiedenen Materialien im Objekt, welche mit dem Einstrahl-Teilchenmikroskop bei Detektion der Rückstreuelektronen einfach sichtbar gemacht werden können, kaum detektierbar sind.

Die an der Multi-Aperturplatte 11 vorgesehene Konverterschicht 403 ist dazu konfiguriert, Rückstreuelektronen in Sekundärelektronen 409 zu konvertieren. Hierzu treffen Rückstreuelektronen 407, welche an einem Ort 5 in der Ebene 101 aus dem Objekt 7 austreten, auf die dem Objekt 7 zugewandte Seite der Konverterschicht 403, und zwar in den Bereichen, in denen die Konverterschicht 403 nicht von dem Substrat 401 unterstützt wird. Die Rückstreuelektronen 407 erzeugen in der Konverterschicht 403 Sekundärelektronen, von welchen wenigstens ein Teil 409 auf der von dem Objekt 7 abgewandten Seite der Konverterschicht 403 aus dieser austreten. Diese konvertierten Sekundärelektronen 409 weisen bei ihrem Austritt aus der Konverterschicht 403 eine kinetische Energie auf, welche wesentlich geringer ist als die kinetische Energie der Rückstreuelektronen 407 bei deren Austritt aus dem Objekt 7. Diese Sekundärelektronen 409 weisen insbesondere geringe Geschwindigkeitskomponenten parallel zu der Objektebene 101 auf und werden in dem zwischen der Objektivlinse 102 und dem Objekt 7 bereitgestellten elektrischen Feld weg von dem Objekt 7 beschleunigt und können durch die Sekundäroptik 12 der Detektoranordnung 209 zugeführt werden, ohne dass die Trajektorien von Sekundärelektronen 409, welche aus Rückstreuelektronen 407 erzeugt werden, die von verschiedenen Orten 5 an der Oberfläche des Objekts 7 ausgehen, überlappen. Damit können diese Sekundärelektronen 409 Elektronenstrahlen formen, welche durch die Sekundäroptik 12 als separate Strahlen der Detektoranordnung zugeführt werden. Insbesondere können diese Sekundärelektronen 409 gemeinsam mit den Sekundärelektronen, welche direkt an den Auftrefforten 5 aus dem Objekt 7 austreten und die Öffnungen 37 durchsetzen, Elektronenstrahlen bilden, deren Intensitäten von der Detektoranordnung detektierbar sind. Die Konverterschicht 403 ermöglicht es somit, Messsignale zu erzeugen, welche einem bestimmten Auftreffort 5 eines PrimärElektronenstrahls 3 auf dem Objekt 7 zuordenbar sind und die Intensität der an diesem Ort 5 erzeugten Rückstreuelektronen 407 repräsentieren.

Hierbei ist es möglich, das Vielstrahlen-Teilchenmikroskop 1 in zwei voneinander verschiedenen Betriebsmoden zu betreiben. In einem ersten der beiden Betriebsmoden ist das Potential U3, welches der Multi-Aperturplatte 11 zugeführt wird, größer als das Potential U4, welches dem Objekt 7 zugeführt wird. Hierdurch werden die aus der Oberfläche des Objekts 7 austretenden Sekundärelektronen hin zu der Multi-Aperturplatte 11 beschleunigt und durchsetzen teilweise die Öffnungen 37 in der Konverterschicht 403, so dass diese Sekundärelektronen zu den Elektronenstrahlen beitragen, welche aus den Sekundärelektronen 409 gebildet werden, welche aus der Konverterschicht 403 nach Umwandlung aus Rückstreuelektronen 407 gebildet werden. In dem ersten Betriebsmodus werden somit sowohl Sekundärelektronen als auch Rückstreuelektronen, welche aus dem Objekt 7 austreten, detektiert.

In einem zweiten der beiden Betriebsmoden ist das der Multi-Aperturplatte 11 zugeführte elektrische Potential U3 kleiner als das dem Objekt 7 zugeführte elektrische Potential U4. Dies führt dazu, dass die aus dem Objekt austretenden Sekundärelektronen niedriger kinetische Energie die Multi-Aperturplatte 11 nicht erreichen und insbesondere nicht durch die Öffnungen 37 in der Konverterschicht 403 hindurchtreten können. Die aus dem Objekt austretenden Sekundärelektronen erzeugen deshalb keine durch die Detektoranordnung erzeugten Detektionssignale. Lediglich Rückstreuelektronen werden in dem zweiten Betriebsmodus detektiert.

Die Konverterschicht 403 besteht vorzugsweise aus einem Material mit großer Kernladungszahl. Ein Beispiel für ein geeignetes Material ist Gold. Eine Dicke d der Konverterschicht ist so bemessen, dass Rückstreuelektronen 407, welche auf die dem Objekt 7 zugewandte Seite der Konverterschicht 407 treffen, zu einer hohen Zahl von Sekundärelektronen 409 führen, welche auf der von dem Objekt 7 abgewandten Seite der Konverterschicht 403 aus dieser austreten. Die derart bestimmte optimale Dicke hängt von der kinetischen Energie der Rückstreuelektronen 407 ab und ist damit wiederum abhängig von der kinetischen Energie mit der die Primärteilchen auf das Objekt auftreffen. Allerdings muss die Dicke d der Konverterschicht 403 nicht dieser optimalen Dicke entsprechen, und es ist möglich, eine Konverterschicht 403 einer gegebenen Dicke d für einen breiten Bereich an kinetischen Energien der Primärteilchen beim Auftreffen auf das Objekt einzusetzen. Die Dicke der Konverterschicht kann beispielsweise in einem Bereich einer Atomlage bis 40 nm oder 0,5 nm bis 20 nm liegen.

Das Substrat 401 ist aus einem Material gebildet, welches die Funktion erfüllen kann, als tragende Struktur für die Konverterschicht 403 zu dienen. Beispielsweise kann das Substrat 401 aus einem Silizium-Einkristall gebildet sein. Hierzu kann eine Platte aus einem Silizium-Einkristall, welcher das Substrat 401 der Multi-Aperturplatte 11 bildet, mit einem Material beschichtet werden, welches die Konverterschicht 403 der Multi-Aperturplatte 11 bildet, und die Öffnungen 405 in der Siliziumplatte und die Öffnungen 37 in der Konverterschicht 403 können durch lithographische Verfahren in die Siliziumplatte bzw. die Konverterschicht eingebracht werden, um die Multi-Aperturplatte 11 zu fertigen.

Figur 4 zeigt eine der Figur 3 entsprechende Darstellung einer Multi-Aperturplatte 11, welche dazu konfiguriert ist, Rückstreuelektronen in Sekundärelektronen umzuwandeln, welche Elektronenstrahlen bilden, welche durch die Sekundäroptik 12 als separate Strahlen der Detektoranordnung 209 zugeführt werden.

Bei dem in Figur 4 gezeigten Beispiel einer Multi-Aperturplatte ist das Konvertermaterial nicht als Schicht 403 auf einer Flachseite eines Substrats 401 der Multi-Aperturplatte 11 aufgebracht, wie dies in dem Beispiel der Figur 3 der Fall ist, sondern es ist als Schicht an Innenwänden von Öffnungen 405 in dem Substrat 401 angebracht. Damit bilden die Oberflächen der Schichten 411 aus Konvertermaterial die Öffnungen 37 der Multi-Aperturplatte 11, welche von den Primärstrahlen 3 durchsetzt werden. Aus dem Objekt 7 austretende Rückstreuelektronen 407 treffen auf die Konverterschicht 411 innerhalb der Aperturen 37 und werden in Sekundärelektronen 409 umgewandelt, welche aus der Schicht 411 in die Öffnung 37 hinein austreten. Diese aus der Konverterschicht austretenden Sekundärelektronen 409 werden durch das zwischen der Objektivlinse und dem Objekt 7 bereitgestellte elektrische Feld weg von dem Objekt 7 beschleunigt und bilden Strahlen, welche durch die Sekundäroptik 12 der Detektoranordnung 211 zugeführt werden. Somit ist es auch mit einer Multi-Aperturplatte 11 gemäß der in Figur 4 gezeigten Ausführungsform möglich, aus dem Objekt 7 austretende Elektronen 407 in Sekundärelektronen umzuwandeln, welche durch die Detektoranordnung 209 detektierbar sind. Auch die Multi-Aperturplatte der in Figur 4 gezeigten Ausführungsform ist in den beiden Betriebsmoden betreibbar, welche vorangehend im Zusammenhang mit der Figur 3 erläutert wurden. Diese beiden Betriebsmoden ermöglichen es, sowohl Rückstreuelektronen alleine als auch Rückstreuelektronen und Sekundärelektronen, welche beide aus dem Objekt 7 austreten, zu detektieren.

Bezugszeichen 407' in Figur 4 bezeichnet ein Rückstreuelektron, welches mit einer großen Geschwindigkeitskomponente parallel zur Objektebene 101 an einem Ort 5 von der Oberfläche des Objekts 7 ausgeht. Diesem Rückstreuelektron 407' gelingt es, auf die Konverterschicht 411 an der Innenwand der Ausnehmung 37 zu treffen, welche dem Auftreffort 5 des Primärstrahls 3 zugeordnet ist, welcher von dem Ort verschieden ist, von dem das Rückstreuelektron 407 ausgeht. Das Rückstreuelektron 407 erzeugt damit Sekundärelektronen 409 in der "falschen" Ausnehmung 37, und die daraus resultierenden Detektionsereignisse werden somit dem falschen Primär-Teilchenstrahl 3 zugeordnet. Dieser Effekt kann als Übersprechen ("cross talk") zwischen verschiedenen Teilchenstrahlen bezeichnet werden.

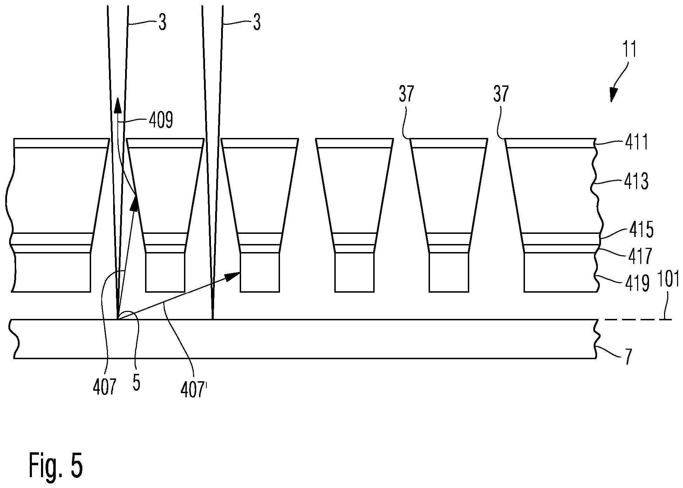

Figur 5 zeigt einen Querschnitt einer Multi-Aperturplatte 11 gemäß einer weiteren Ausführungsform, bei welcher dieser Effekt des Übersprechens reduziert ist.

Die in Figur 5 im Querschnitt gezeigte Multi-Aperturplatte 11 weist einen mehrschichtigen Aufbau auf, in welchem die Aperturen 37 angebracht sind. Folgende Schichten sind in der Darstellung der Figur 5 von oben nach unten, d. h. in Richtung hin zu der Objektebene 101 vorgesehen: Eine elektrisch leitende Schicht 411, eine Konverterschicht 413, welche elektrisch isolierend ist, eine elektrisch leitende Schicht 415, eine elektrisch isolierende Schicht 417 und eine Absorberschicht 419, welche elektrisch leitend ist.

Hierbei kann es vorteilhaft sein, wenn die elektrisch leitenden Schichten 411, 415 oder 419 sich auf einem vorbestimmten elektrischen Potential befinden, welches derart bestimmt ist, dass die Primärstrahlen 3 durch zwischen den elektrisch leitenden Schichten 411, 415 und 419 entstehende elektrische Felder nicht wesentlich beeinflusst werden. Ferner ist es möglich, dass elektrisch isolierende Konverterschicht 413 einen ausreichend großen verbleibenden Widerstand derart aufweist, dass durch die Schicht hindurch ein Strom fließen kann, welcher während des Betriebs die Potentiale der elektrisch leitenden Schichten 411, 415 und 419 definiert.

Die Konverterschicht 413 ist entweder insgesamt aus einem Rückstreuelektronen 407 in Sekundärelektronen 409 konvertierenden Material gebildet, welches an den Innenwänden der Ausnehmung 37 frei liegt, oder sie ist aus einem lediglich elektrisch isolierenden Material gebildet, bei dem an den Innenwänden der Ausnehmungen 37 Schichten aus einem Konvertermaterial angebracht sind, wie dies vorangehend im Zusammenhang mit der in Figur 4 gezeigten Ausführungsform erläutert wurde.

Die Absorberschicht 419 besteht aus einem Material, welches pro auftreffenden Rückstreuelektron sehr wenige Sekundärelektronen und insbesondere wesentlich weniger Sekundärelektronen als das Konvertermaterial erzeugt.

Hierbei kann es vorteilhaft sein, die Schichten so auszulegen, dass während des Betriebs die Absorberschicht 419 ein um beispielswiese 10 V, 20 V oder 50 V höheres elektrisches Potential aufweist als die Konverterschicht 413, um zu verhindern, dass an dem Absorber erzeugte Sekundärelektronen zum Konverter und von da zum Detektor gelangen.

Mit dem Bezugszeichen 407 in Figur 5 ist ein Rückstreuelektron bezeichnet, welches von einem Ort 5 auf der Oberfläche des Objekts 7 austritt und die Innenwand derjenigen Apertur 37 trifft, welche dem Ort 5 zugeordnet ist, von dem das Rückstreuelektron 407 ausgeht. Das Rückstreuelektron 407 wird an der Innenwand der Ausnehmung 37 in der Konverterschicht 413 in ein oder mehrere Sekundärelektronen 409 umgewandelt, von denen einige an der von dem Objekt 7 abgewandten Seite der Multi-Aperturplatte aus der Öffnung 37 austreten und wie vorangehend beschrieben, von der Detektoranordnung derart detektiert werden können, dass sie dem richtigen Primär-Teilchenstrahl 3 zugeordnet werden können.

Mit dem Bezugszeichen 407' in Figur 5 ist ein Rückstreuelektron 407 gezeigt, welches auf die Innenwand der benachbarten Öffnung 37 und damit auf die Innenwand der "falschen" Öffnung trifft und damit potentiell ein Übersprechen zwischen verschiedenen detektierten Elektronenstrahlen erzeugen kann. Allerdings sind die Geometrie der Öffnungen 37, die Dicke der Absorberschicht 419 und der Abstand zwischen der dem Objekt 7 zuweisenden Oberfläche der Multi-Aperturplatte 11 bzw. der Absorberschicht 419 und der Oberfläche des Objekts 7 so gewählt, dass die von dem Ort 5 ausgehenden Rückstreuelektronen 407', welche in die benachbarte, "falsche" Öffnung 37 treffen, dort lediglich auf Innenoberflächen der Öffnung 37 treffen, welche im Bereich der Absorberschicht 419 liegen. Dort werden diese auftreffenden Rückstreuelektronen 407' allerdings nicht oder in lediglich sehr geringem Maße in Sekundärelektronen umgewandelt, welche schließlich detektiert werden.

In dem Ausführungsbeispiel der Figur 5 ist das Spannungsversorgungssystem dazu konfiguriert, an die leitenden Schichten 411, 415 und 419 verschiedene und jeweils einstellbare elektrische Potentiale anzulegen. Insbesondere sind hierdurch folgende Betriebsweisen möglich:
Die dem Objekt 7 am nächsten angeordnete Schicht 419 kann relativ zu dem Objekt 7 auf größeres oder kleineres elektrisches Potential gelegt werden, um die vorangehend im Zusammenhang mit der Figur 3 beschriebenen zwei Betriebsmoden zu realisieren, in welchen von dem Objekt ausgehende Rückstreuelektronen und Sekundärelektronen gemeinsam detektiert werden oder lediglich Rückstreuelektronen detektiert werden.

Zwischen den leitenden Schichten 411 und 415 kann eine Potentialdifferenz angelegt werden, welche innerhalb der Ausnehmungen 37 im Bereich der Konverterschicht 413 ein elektrisches Feld erzeugt, welches die an den Wänden der Ausnehmung 37 erzeugten Sekundärelektronen in der Figur 5 nach oben und damit weg von dem Objekt 7 beschleunigt. Hierdurch wird die Wahrscheinlichkeit erhöht, dass ein an der Wand der Ausnehmung 37 erzeugtes Sekundärelektron auch an der Oberseite der Multi-Aperturplatte 11 aus der Öffnung 37 austritt und nicht etwa innerhalb der Öffnung absorbiert wird.

Die Öffnungen 37 können ferner, wie in Figur 5 dargestellt, eine konische Gestalt aufweisen, so dass die Querschnittsfläche der Ausnehmungen 37 in die Richtung hin zu dem Objekt 7 zunimmt. Zusammen mit der Bereitstellung der Absorberschicht 419 ist es damit möglich, den Raumwinkel zu erhöhen, unter dem die Rückstreuelektronen 407 von dem Ort 5 an der Oberfläche des Objekts 7 ausgehen können und an der Innenwand der zugeordneten Ausnehmung 37 in Sekundärelektronen 409 umgewandelt werden, ohne die Wahrscheinlichkeit des Übersprechens zu erhöhen.

Bei diesem Ausführungsbeispiel ist der Durchmesser der Ausnehmungen 37 auf den Strahldurchmesser der Primär-Teilchenstrahlen 3 so abgestimmt, dass die Primärteilchen vor dem Auftreffen auf dem Objekt 7 keinen nennenswerten Störuntergrund an von diesen unmittelbar an der Konverterschicht 413 erzeugten Sekundärelektronen verursachen. Beispielsweise beträgt der Strahldurchmesser der Primär-Teilchenstrahlen 3 höchstens 70%, insbesondere höchstens 50% und insbesondere höchstens 20% des Durchmessers der Ausnehmungen in den Schichten 411 oder 413. Der Kipppunkt des Strahlablenksystems zum Abscannen des Objekts 7 mit den Primär-Teilchenstrahlenbündeln 3 sollte so nahe an der Ebene des Substrats 401 der Multi-Aperturplatte liegen, dass auch beim Abscannen des Objekts eine Auswanderung der Primär-Teilchenstrahlen 3 innerhalb der Ausnehmungen 37 hinreichend klein bleibt, so dass die Primärteilchen vor dem Auftreffen auf dem Objekt 7 keinen nennenswerten Störuntergrund an von diesen unmittelbar an der Konverterschicht 413 erzeugten Sekundärelektronen verursachen.

## Patentansprüche

1. Vielstrahl-Teilchenmikroskop, umfassend:
eine Vielstrahl-Teilchenquelle (300), welche dazu konfiguriert ist, eine Vielzahl von Primär-Teilchenstrahlen (3) zu erzeugen;
eine Objektivlinse (102), welche von Strahlengängen der Vielzahl von Primär-Teilchenstrahlen (3) durchsetzt ist und dazu konfiguriert ist, die Vielzahl von Primär-Teilchenstrahlen (3) jeweils auf eine Objektebene (101) zu richten und dort zu fokussieren; und
eine Detektoranordnung (200), welche dazu konfiguriert ist, Intensitäten einer Vielzahl von Elektronenstrahlen (9) zu detektieren, wobei Elektronen der Elektronenstrahlen (9) durch Teilchen der Primär-Teilchenstrahlen (3) an einem in der Objektebene (101) anordenbaren Objekt (7) erzeugt werden;
**gekennzeichnet durch**
eine zwischen der Objektivlinse (102) und der Objektebene (101) angeordnete Multi-Aperturplatte (11), welche mit Abstand von der Objektebene (101) angeordnet ist und eine Vielzahl von Öffnungen (37) aufweist,
wobei verschiedene Öffnungen (37) der Multi-Aperturplatte (11) von Strahlengängen verschiedener Primär-Teilchenstrahlen (3) durchsetzt sind, und wobei die Multi-Aperturplatte (11) eine Vielzahl von Konvertern (403; 411; 413) umfasst, wobei an jeder Öffnung der Vielzahl von Öffnungen wenigstens ein Konverter der Vielzahl von Konvertern vorgesehen ist, wobei die Konverter dazu konfiguriert sind, von den Primär-Teilchenstrahlen an dem Objekt erzeugte Rückstreuelektronen, welche an dem Objekt kinetische Energien aufweisen, die größer sind als ein vorbestimmter erster Energieschwellwert, in Elektronen umzuwandeln, welche an dem Konverter kinetische Energien aufweisen, die kleiner sind als ein vorbestimmter zweiter Energieschwellwert und welche Elektronen bereitstellen, die die von der Detektoranordnung detektierten Elektronenstrahlen bilden.

2. Vielstrahl-Teilchenmikroskop nach Anspruch 1, wobei die Konverter jeweils dünne Membranen (403) umfassen, welche im Wesentlichen parallel zu der Objektebene (101) orientiert sind.

3. Vielstrahl-Teilchenmikroskop nach Anspruch 2, wobei die an dem Objekt erzeugten Rückstreuelektronen auf die der Objektebene zugewandte Oberfläche der Membranen auftreffen und die aus den Rückstreuelektronen umgewandelten Elektronen aus der von der Objektebene abgewandten Oberfläche der Membranen austreten.

4. Vielstrahl-Teilchenmikroskop nach Anspruch 2 oder 3, wobei die Membranen eine Dicke von 0,5 nm bis 50 nm, insbesondere 4 nm bis 20 nm aufweisen.

5. Vielstrahl-Teilchenmikroskop nach einem der Ansprüche 1 bis 4, wobei die Öffnungen der Multi-Aperturplatte auf ihrer der Objektebene zugewandten Seite eine erste Querschnittsfläche und auf ihrer von der Objektebene abgewandten Seite eine zweite Querschnittsfläche aufweisen, wobei die erste Querschnittsfläche wenigstens 1,5 mal und insbesondere wenigstens 2,0 mal größer ist als die zweite Querschnittsfläche.

6. Vielstrahl-Teilchenmikroskop nach einem der Ansprüche 1 bis 5, ferner umfassend ein Spannungsversorgungssystem (27), welches dazu konfiguriert ist, dem Objekt und der Multi-Aperturplatte jeweils ein einstellbares elektrisches Potential zuzuführen; wobei insbesondere
das Spannungsversorgungssystem dazu konfiguriert ist, in einem ersten Betriebsmodus einer dem Objekt zuweisenden Seite der Multi-Aperturplatte und dem Objekt elektrische Potentiale derart zuzuführen, dass das Objekt relativ zu der Multi-Aperturplatte auf einem negativen elektrischen Potential liegt, so dass an dem Objekt erzeugte Sekundärelektronen die Öffnungen der Multi-Aperturplatte durchsetzen und ebenfalls Elektronen bereitstellen, die die von der Detektoranordnung detektierten Elektronenstrahlen bilden; und
das Spannungsversorgungssystem dazu konfiguriert ist, in einem zweiten Betriebsmodus der dem Objekt zuweisenden Seite der Multi-Aperturplatte und dem Objekt elektrische Potentiale derart zuzuführen, dass das Objekt relativ zu der Multi-Aperturplatte auf einem positiven elektrischen Potential liegt, so dass an dem Objekt erzeugte Sekundärelektronen die Öffnungen der Multi-Aperturplatte nicht durchsetzen.

7. Vielstrahl-Teilchenmikroskop nach Anspruch 6, wobei die Multi-Aperturplatte drei voneinander isolierte leitfähige Schichten (411, 415, 419) umfasst, wobei das Spannungsversorgungssystem dazu konfiguriert ist, den drei leitfähigen Schichten jeweils einstellbare elektrische Potentiale zuzuführen.

8. Vielstrahl-Teilchenmikroskop nach einem der Ansprüche 1 bis 7, ferner umfassend eine Vielzahl von Absorbern (405), welche, gesehen in Richtung der Objektebene (101), zwischen einander benachbarten Öffnungen (37) in der Multi-Aperturplatte (11) angeordnet sind und welche, gesehen senkrecht zu der Objektebene, zwischen der Objektebene (101) und den Konvertern (403; 411; 413) angeordnet sind.

9. Vielstrahl-Teilchenmikroskop nach Anspruch 8, wobei die Absorber aus einem Material bestehen, welches aus Atomen besteht, die Kernladungszahlen aufweisen, welche im Mittel kleiner als 40, insbesondere kleiner als 20 und insbesondere kleiner als 15 sind.

10. Vielstrahl-Teilchenmikroskop nach Anspruch 8 oder 9, wobei das Vielstrahl-Teilchenmikroskop so konfiguriert ist, dass die Absorber während des Betriebs relativ zu den Konvertern positiv geladen sind.

11. Vielstrahl-Teilchenmikroskop nach Anspruch 10, wobei zwischen den Absorbern und den Konvertern während des Betriebs ein Potentialunterschied von mehr als 10 V, insbesondere mehr als 20 V und insbesondere mehr als 50 V besteht.

12. Vielstrahl-Teilchenmikroskop nach einem der Ansprüche 1 bis 11, wobei der erste Energieschwellwert größer als 50 eV und insbesondere größer als 200 eV ist; und/oder
wobei der zweite Energieschwellwert kleiner als 200 eV und insbesondere kleiner als 100 eV ist.

13. Vielstrahl-Teilchenmikroskop nach einem der Ansprüche 1 bis 12, wobei die Anzahl der Primär-Teilchenstrahlen größer als 7 ist.

14. Vielstrahl-Teilchenmikroskop nach einem der Ansprüche 1 bis 13, wobei der Abstand kleiner als 200 µm, insbesondere kleiner als 50 µm, insbesondere kleiner als 30 µm, insbesondere kleiner als 20 µm und insbesondere kleiner als 10 µm ist.

15. Vielstrahl-Teilchenmikroskop nach einem der Ansprüche 1 bis 14, wobei ein minimaler Abstand von zwei einander benachbarten Primär-Teilchenstrahlen an der Multi-Aperturplatte kleiner als 50 µm, insbesondere kleiner als 30 µm, insbesondere kleiner als 20 µm und insbesondere kleiner als 12 µm ist.

## Claims

1. Multi-beam particle microscope, comprising:
a multi-beam particle source (300) configured to create a plurality of primary particle beams (3);
an objective lens (102) penetrated by beam paths of the plurality of primary particle beams (3) and configured to direct each of the plurality of primary particle beams (3) to an object plane (101) and to focus said primary particle beams there; and
a detector arrangement (200) configured to detect intensities of a plurality of electron beams (9), electrons in the electron beams (9) being created by particles of the primary particle beams (3) at an object (7) that is arrangeable in the object plane (101);
**characterized by**
a multi-aperture plate (11) arranged between the objective lens (102) and the object plane (101) at a distance from said object plane (101) and having a plurality of openings (37),
wherein different openings (37) of the multi-aperture plate (11) are penetrated by beam paths of different primary particle beams (3), and
wherein the multi-aperture plate (11) comprises a plurality of converters (403; 411; 413), at least one converter of the plurality of converters being provided at each opening of the plurality of openings, the converters being configured to convert backscattered electrons that are created by the primary particle beams at the object and that have higher kinetic energy levels at the object than a predetermined first energy threshold value into electrons that have lower kinetic energy levels at the converter than a predetermined second energy threshold value and that provide electrons which form the electron beams that are detected by the detector arrangement.

2. Multi-beam particle microscope according to Claim 1, wherein the converters each comprise thin membranes (403) that are oriented substantially parallel to the object plane (101).

3. Multi-beam particle microscope according to Claim 2, wherein the backscattered electrons created at the object strike the surface of the membranes facing the object plane and the electrons resulting from the backscattered electrons emerge from the surface of the membranes facing away from the object plane.

4. Multi-beam particle microscope according to Claim 2 or 3, wherein the membranes have a thickness of 0.5 nm to 50 nm, more particularly 4 nm to 20 nm.

5. Multi-beam particle microscope according to any of Claims 1 to 4, wherein the openings in the multi-aperture plate have a first cross-sectional area on their side facing the object plane and a second cross-sectional area on their side facing away from the object plane, the first cross-sectional area being at least 1.5-times and, in particular, at least 2.0-times larger than the second cross-sectional area.

6. Multi-beam particle microscope according to any of Claims 1 to 5, further comprising a voltage supply system (27) configured to supply a respective adjustable electric potential to the object and to the multi-aperture plate; wherein in particular
the voltage supply system is configured in a first mode of operation to supply electric potentials to a side of the multi-aperture plate facing the object and to the object, in such a way that the object is at a negative electric potential relative to the multi-aperture plate such that secondary electrons created at the object pass through the openings in the multi-aperture plate and likewise provide electrons which form the electron beams that are detected by the detector arrangement; and
the voltage supply system is configured in a second mode of operation to supply electric potentials to the side of the multi-aperture plate facing the object and to the object, in such a way that the object is at a positive electric potential relative to the multi-aperture plate such that secondary electrons created at the object do not pass through the openings in the multi-aperture plate.

7. Multi-beam particle microscope according to Claim 6, wherein the multi-aperture plate comprises three conductive layers (411, 415, 419) that are insulated from one another, the voltage supply system being configured to supply respective adjustable electric potentials to the three conductive layers.

8. Multi-beam particle microscope according to any of Claims 1 to 7, further comprising a plurality of absorbers (405) which, as seen in the direction of the object plane (101), are arranged between mutually adjacent openings (37) in the multi-aperture plate (11) and which, as seen perpendicular to the object plane, are arranged between the object plane (101) and the converters (403; 411; 413).

9. Multi-beam particle microscope according to Claim 8, wherein the absorbers consist of a material consisting of atoms that have atomic numbers which, on average, are less than 40, in particular less than 20 and in particular less than 15.

10. Multi-beam particle microscope according to Claim 8 or 9, wherein the multi-beam particle microscope is configured in such a way that, during operation, the absorbers are positively charged relative to the converters.

11. Multi-beam particle microscope according to Claim 10, wherein, during operation, there is a potential difference of more than 10 V, in particular more than 20 V and in particular more than 50 V between the absorbers and the converters.

12. Multi-beam particle microscope according to any of Claims 1 to 11, wherein the first energy threshold value is greater than 50 eV and in particular greater than 200 eV; and/or
wherein the second energy threshold value is less than 200 eV and in particular less than 100 eV.

13. Multi-beam particle microscope according to any of Claims 1 to 12, wherein the number of primary particle beams is greater than 7.

14. Multi-beam particle microscope according to any of Claims 1 to 13, wherein the distance is less than 200 µm, in particular less than 50 µm, in particular less than 30 µm, in particular less than 20 µm and in particular less than 10 µm.

15. Multi-beam particle microscope according to any of Claims 1 to 14, wherein a minimum distance between two mutually adjacent primary particle beams at the multi-aperture plate is less than 50 µm, in particular less than 30 µm, in particular less than 20 µm and in particular less than 12 µm.

## Revendications

1. Microscope à particules multifaisceaux, comprenant :
une source de particules multifaisceaux (300) qui est configurée pour générer une pluralité de faisceaux de particules primaires (3) ;
une lentille d'objectif (102) qui est traversée par des chemins optiques de la pluralité de faisceaux de particules primaires (3) et qui est configurée pour diriger et focaliser la pluralité de faisceaux de particules primaires (3) respectivement sur un plan d'objet (101) ; et
un agencement de détecteur (200) qui est configuré pour détecter des intensités d'une pluralité de faisceaux d'électrons (9), dans lequel les électrons des faisceaux d'électrons (9) sont générés par des particules des faisceaux de particules primaires (3) au niveau d'un objet (7) pouvant être disposé dans le plan d'objet (101) ;
**caractérisé par**
une plaque à ouvertures multiples (11) disposée entre la lentille d'objectif (102) et le plan d'objet (101), qui est disposée à distance du plan d'objet (101) et présente une pluralité d'ouvertures (37),
dans lequel différentes ouvertures (37) de la plaque à ouvertures multiples (11) sont traversées par les chemins optiques de différents faisceaux de particules primaires (3), et
dans lequel la plaque à ouvertures multiples (11) comprend une pluralité de convertisseurs (403 ; 411 ; 413), dans lequel au moins un convertisseur de la pluralité de convertisseurs est prévu à chaque ouverture de la pluralité d'ouvertures, dans lequel les convertisseurs sont configurés pour convertir des électrons rétrodiffusés, générés au niveau de l'objet par les faisceaux de particules primaires et qui présentent des énergies cinétiques au niveau de l'objet qui sont supérieures à une première valeur seuil d'énergie prédéterminée, en électrons qui présentent au niveau du convertisseur des énergies cinétiques qui sont inférieures à une deuxième valeur seuil d'énergie prédéterminée et qui fournissent des électrons qui constituent les faisceaux d'électrons détectés par l'agencement de détecteur.

2. Microscope à particules multifaisceaux selon la revendication 1, dans lequel les convertisseurs comprennent respectivement des membranes fines (403) qui sont orientées substantiellement en parallèle au plan d'objet (101).

3. Microscope à particules multifaisceaux selon la revendication 2, dans lequel les électrons rétrodiffusés générés au niveau de l'objet sont incidents sur la surface des membranes tournée vers le plan d'objet et les électrons convertis à partir des électrons rétrodiffusés sortent de la surface des membranes détournée du plan d'objet.

4. Microscope à particules multifaisceaux selon la revendication 2 ou 3, dans lequel les membranes présentent une épaisseur de 0,5 nm à 50 nm, en particulier de 4 nm à 20 nm.

5. Microscope à particules multifaisceaux selon l'une quelconque des revendications 1 à 4, dans lequel les ouvertures de la plaque à ouvertures multiples présentent une première superficie de la section sur leur face tournée vers le plan d'objet et une deuxième superficie de la section sur leur face détournée du plan d'objet, dans lequel la première superficie de la section est au moins 1,5 fois et en particulier au moins 2,0 fois supérieure à la première superficie de la section.

6. Microscope à particules multifaisceaux selon l'une quelconque des revendications 1 à 5, comprenant en outre un système d'alimentation en tension (27) qui est configuré pour amener respectivement un potentiel électrique réglable à l'objet et à la plaque à ouvertures multiples ; dans lequel en particulier
le système d'alimentation en tension est configuré pour amener dans un premier mode de fonctionnement des potentiels électriques à une face, tournée vers l'objet, de la plaque à ouvertures multiples et à l'objet de telle sorte que l'objet est à un potentiel électrique négatif par rapport à la plaque à ouvertures multiples, de sorte que des électrons secondaires générés au niveau de l'objet traversent les ouvertures de la plaque à ouvertures multiples et fournissent également des électrons qui constituent les faisceaux d'électrons détectés par l'agencement de détecteur ; et
le système d'alimentation en tension est configuré pour amener dans un deuxième mode de fonctionnement des potentiels électriques à la face, tournée vers l'objet, de la plaque à ouvertures multiples et à l'objet de telle sorte que l'objet est à un potentiel électrique positif par rapport à la plaque à ouvertures multiples, de sorte que des électrons secondaires générés au niveau de l'objet ne traversent pas les ouvertures de la plaque à ouvertures multiples.

7. Microscope à particules multifaisceaux selon la revendication 6, dans lequel la plaque à ouvertures multiples comprend trois couches conductrices (411, 415, 419) isolées les unes des autres, dans lequel le système d'alimentation en tension est configuré pour amener des potentiels électriques respectivement réglables aux trois couches conductrices.

8. Microscope à particules multifaisceaux selon l'une quelconque des revendications 1 à 7, comprenant en outre une pluralité d'absorbeurs (405) qui sont disposés, vus dans la direction du plan d'objet (101), entre des ouvertures (37) voisines les unes des autres dans la plaque à ouvertures multiples (11), et qui, vus perpendiculairement au plan d'objet, sont disposés entre le plan d'objet (101) et les convertisseurs (403 ; 411 ; 413).

9. Microscope à particules multifaisceaux selon la revendication 8, dans lequel les absorbeurs sont composés d'un matériau qui est composé d'atomes qui présentent des numéros atomiques qui sont en moyenne inférieurs à 40, en particulier inférieurs à 20 et en particulier inférieurs à 15.

10. Microscope à particules multifaisceaux selon la revendication 8 ou 9, dans lequel le microscope à particules multifaisceaux est configuré de telle sorte qu'en cours de fonctionnement, les absorbeurs sont chargés positivement par rapport aux convertisseurs.

11. Microscope à particules multifaisceaux selon la revendication 10, dans lequel en cours de fonctionnement, il existe une différence de potentiel de plus de 10 V, en particulier de plus de 20 V et en particulier de plus de 50 V entre les absorbeurs et les convertisseurs.

12. Microscope à particules multifaisceaux selon l'une quelconque des revendications 1 à 11, dans lequel la première valeur seuil d'énergie est supérieure à 50 eV et en particulier supérieure à 200 eV ; et/ou
dans lequel la deuxième valeur seuil d'énergie est inférieure à 200 eV et en particulier inférieure à 100 eV.

13. Microscope à particules multifaisceaux selon l'une quelconque des revendications 1 à 12, dans lequel le nombre des faisceaux de particules primaires est supérieur à 7.

14. Microscope à particules multifaisceaux selon l'une quelconque des revendications 1 à 13, dans lequel la distance est inférieure à 200 µm, en particulier inférieure à 50 µm, en particulier inférieure à 30 µm, en particulier inférieure à 20 µm et en particulier inférieure à 10 µm.

15. Microscope à particules multifaisceaux selon l'une quelconque des revendications 1 à 14, dans lequel une distance minimale de deux faisceaux de particules primaires voisins l'un de l'autre sur la plaque à ouvertures multiples est inférieure à 50 µm, en particulier inférieure à 30 µm, en particulier inférieure à 20 µm et en particulier inférieure à 12 µm.
